(19) Europäisches Patentamt
European Patent Office
Office européen des brevets

(11) **EP 4 130 803 A1**

(12) **EUROPEAN PATENT APPLICATION**
published in accordance with Art. 153(4) EPC

(43) Date of publication:
**08.02.2023 Bulletin 2023/06**

(21) Application number: **21779926.1**

(22) Date of filing: **30.03.2021**

(51) International Patent Classification (IPC):
***G01T 1/34*** (1968.09)

(52) Cooperative Patent Classification (CPC):
**G01T 1/34**

(86) International application number:
**PCT/CN2021/083775**

(87) International publication number:
**WO 2021/197291 (07.10.2021 Gazette 2021/40)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **31.03.2020 CN 202010244303**

(71) Applicant: **Liu, Changyuan**
**Shenyang, Liaoning 110021 (CN)**

(72) Inventor: **Liu, Changyuan**
**Shenyang, Liaoning 110021 (CN)**

(74) Representative: **Herzog IP Patentanwalts GmbH**
**Steinstraße 16-18**
**40212 Düsseldorf (DE)**

(54) **NUCLEAR CROSS SECTION DOPPLER BROADENING METHOD AND APPARATUS**

(57)    The present invention relates to a nuclear cross section Doppler broadening method and device. The method includes: discretizing a product $F(x,\theta)$ of an average reaction cross section function $\sigma(E, T)$ and an energy $E$ on grids equally divided on a square root $N$ of the energy as $F_k^c(\theta)$, where incident particles have mass $m$ and energy $E$, target particles have mass $M$ and Maxwellian energy distribution under a temperature $T$, and $F(x, \theta) = E\sigma(E, T)$, $F_k^c(\theta) = F(x_k, \theta)$, $k = 0,1,... N - 1$, $x = \sqrt{E}$, and $c$ are discrete superscript symbols; expanding the product $F(x, \theta)$ of the average reaction cross section function and the energy on a group of orthogonal function sets, an expansion coefficient is $\hat{f}_j(\theta)$, and $j$ is an index of the orthogonal function sets, where for the discretized product $F_k^c(\theta)$ of the average reaction cross section function and the energy, an orthogonal function expansion coefficient thereof is $\hat{f}_j^c(\theta) \approx \hat{f}_j(\theta)$; based on the product $F(x, 0)$ of the average reaction cross section function and the energy under a 0 K temperature, obtaining a group of coefficient weights $\hat{f}_j^c(0)$, where $\hat{f}_j^c(\theta)$ is a function of $\hat{f}_j^c(0)$; and representing $F(x, \theta)$ as a sum of an orthogonal function of the group of coefficient weights, using the group of coefficient weights $\hat{f}_j^c(\theta)$, calculating F($x, \theta$), and obtaining an average reaction cross section $\sigma(E, T)$.

FIG. 1

**Description**

**Technical Field**

The present invention relates to the field of nuclear technology, and in particular, to a nuclear cross section Doppler broadening method and device.

**Background**

Particle reactions are the basis of nuclear applications. The nuclear cross section reflects the probability of a nuclear reaction between the particles and the nucleus of the target material, and the accuracy of the calculation result is very high. The temperature reflects the thermal motion of the target material. Different temperatures of the target materials lead to different relative speeds of particles with the same incident speed, which expands the width of a resonance peak on a resonance cross section curve. This effect is referred to as a Doppler effect. Taking a nuclear reaction between neutrons and reactor fuel components as an example, the temperature in the reactor is highly uneven, and a temperature span can reach about 200-3000 K in a volume of 10* 10* 10 $cm^3$. Therefore, accurate calculation of the Doppler broadening is crucial for reactors. However, the nuclear cross section is a complex function of the temperature of the target material, and therefore, the Doppler broadening is a difficult problem to solve.

The existing Doppler broadening algorithms can be roughly divided into two categories: one category is a representation method based on a point energy cross section, which uses different energy-cross section tables at different temperatures; the other category relates to an expansion based on an analytically function of the cross section in energy and temperature. The first category of methods requires a group of point cross section representations for each reaction at each temperature. Since there are hundreds of nuclides, the computer internal storage required to be used may be up to tens of GBs, and the calculation density is low, which is not suitable for large-scale parallel calculation on the current computer architecture. The Chinese patent application with an application No. 201610782544.7 and entitled "FAST NUCLEAR CROSS SECTION DOPPLER EXPANSION METHOD", discloses a relatively fast method in the second category of methods, which uses an expression of the nuclear cross section at temperature T represented by a pole of the 0 K nuclear cross section to compute the nuclear cross section at temperature T. However, a Faddeeva function that needs to be calculated by this method needs consuming expensive calculation resources, and many conditional branches make parallel calculation inefficient.

**Summary**

For the technical problems existing in the prior art, the present invention provides a nuclear cross section Doppler broadening method, which includes: discretizing a product F(x, $\theta$) of an average reaction cross section function $\sigma(E, T)$ and an energy $E$ on grids equally divided on a square root $N$ of the energy as $F_k^c(\theta)$, where incident particles have mass $m$ and energy $E$, target particles have mass $M$ and Maxwellian energy distribution under a temperature $T$, and F(x, $\theta$) = E$\sigma(E, T)$, $F_k^c(\theta) = F(x_k, \theta)$, k = 0, 1, ... N - 1, $x = \sqrt{E}$, and c are discrete superscript symbols; expanding the product F(x, $\theta$) of the average reaction cross section function and the energy on a group of orthogonal function sets, an expansion coefficient is $\hat{f}_j(\theta)$, and j is an index of the orthogonal function sets, where for the discretized product $F_k^c(\theta)$ of the average reaction cross section function and the energy, an orthogonal function expansion coefficient thereof is $\hat{f}_j^c(\theta) \approx \hat{f}_j(\theta)$; based on the product F(x,0) of the average reaction cross section function and the energy under a 0 K temperature, obtaining a group of coefficient weights $\hat{f}_j^c(0)$, where $\hat{f}_j^c(\theta)$ is a function of $\hat{f}_j^c(0)$; and representing F(x, $\theta$) as a sum of an orthogonal function of the group of coefficient weights, using the group of coefficients $\hat{f}_j^c(\theta)$, calculating F(x, $\theta$), and obtaining an average reaction cross section $\sigma''(E,)$.

In the method above, for the grids equally divided on the square root of the energy, a size of the grid is $N$, a maximum energy point is a grid point $E_{max}$, and an energy at a spot where a grid index is $n$ is $e_n$, meeting the following condition:

$$e_n = x_n^2$$

$$x_n = n\Delta x$$

$$\Delta x = \sqrt{E_{max}}/(N-1)$$

$$n = 0, 1, \ldots N - 1. \quad ;$$

where $F(x,\theta)$ is discretized on the grids equally divided on the square root $N$ of the energy:

$$F_k^c(\theta) = F(x_k, \theta), \ k = 0, 1, \ldots N - 1,$$

$$F_0^c(\theta) = F(0, \theta) = 0.$$

In the method above, it further includes: performing orthogonal transformation on the product $F(x, \theta)$ of the average reaction cross section function and the energy; and performing discrete orthogonal transformation on the discretized product $F_k^c(\theta)$ of the average reaction cross section function and the energy.

In the method above, it further includes: performing Fourier transform on the product $F(x,\theta)$ of the average reaction cross section function and the energy; and performing discrete Fourier transformation on the discretized product $F_k^c(\theta)$ of the average reaction cross section function and the energy.

In the method above, it further includes: performing cosine transformation or equivalent transformation of the cosine transformation on the product $F(x,\theta)$ of the average reaction cross section function and the energy; and performing discrete cosine transformation or equivalent transformation of the discrete cosine transformation on the discretized product $F_k^c(\theta)$ of the average reaction cross section function and the energy.

In the method above, a basis for the cosine transformation is $\cos(2\pi\omega_j x)$, and a frequency thereof is

$$\omega_j = \frac{2j + 1}{4N\Delta x}, \text{ and then}$$

$$\hat{f}_j(\theta) = \int_0^{N\Delta x} F(x, \theta) \cos(2\pi x \omega_j) dx \quad ;$$

a basis for the discrete cosine transformation is $\cos(2\pi\omega_j x_k)$, and then

$$\hat{f}_j^c(\theta) = \sum_{k=0}^{N-1} F_k^c(\theta) \cos(2\pi\omega_j x_k)\Delta x \quad ;$$

where $j = 0, 1, \ldots N - 1$ is an integer; and where a function relation between $\hat{f}_j^c(\theta)$ and $\hat{f}_j^c(0)$ is:

$$\hat{f}_j^c(\theta) \approx \hat{f}_j^c(0)e^{-(2\pi\omega_j)^2\theta}.$$

In the method above, when the orthogonal transformation is the cosine transformation, $F(x,\theta)$ is represented as a sum of an orthogonal function of the group of coefficient weights as follows:

$$F(x,\theta) \approx \frac{1}{\Delta x}\frac{2}{N}\sum_{j=0}^{N-1}\hat{f}_j^c(0)e^{-(2\pi\omega_j)^2\theta}\cos(2\pi x\omega_j)$$

.

In the method above, only first $N_{sparse}$ sparse items in $F(x,\theta)$ expansion are reserved:

$$F(x,\theta) \approx \frac{1}{\Delta x}\frac{2}{N}\sum_{j=0}^{N_{sparse}-1}\hat{f}_j^c(0)e^{-(2\pi\omega_j)^2\theta}\cos(2\pi x\omega_j)$$

;

where $N_{sparse}$ is less than $N$.

In the method above, based on a predetermined precision threshold, $N_{sparse}$ is determined.

In the method above, the predetermined precision threshold is represented by a maximum value in absolute values of relative errors at an energy grid point $e_k$ of a reserving N item and a reserving $N_{sparse}$ item in $F(x,\theta)$ expansion, where $k = 0,1,... N - 1$; and where the predetermined precision threshold is less than or equal to 0.001, i.e.,

$$\max_{0\leq k\leq N-1}\left|\frac{\sigma_k^{N_{sparse}}(\theta)-\sigma_k^N(\theta)}{\sigma_k^N(\theta)}\right| \leq 0.001$$

where

$$\sigma_k^{N_{sparse}}(\theta) = \frac{1}{x_k^2}\frac{1}{\Delta x}\frac{2}{N}\sum_{j=0}^{N_{sparse}-1}\hat{f}_j^c(0)e^{-(2\pi\omega_j)^2\theta}\cos(2\pi x_k\omega_j)$$

$$\sigma_k^N(\theta) = \frac{1}{x_k^2}\frac{1}{\Delta x}\frac{2}{N}\sum_{j=0}^{N-1}\hat{f}_j^c(0)e^{-(2\pi\omega_j)^2\theta}\cos(2\pi x_k\omega_j)$$

.

In the method above, $N_{sparse}$ is less than 500,000, or less than 1,000,000.

In the method above, the predetermined precision threshold is a precision threshold corresponding to a lower limit of a preset temperature range.

In the method above, the lower limit of the preset temperature range is 200 K.

In the method above, in a lower energy region, $F(x, 0)$ of 0 K is used, and $F(x, \theta)$ is calculated based on the following formula:

$$F(x,\theta) = \frac{1}{\sqrt{4\pi\theta}}\int_0^\infty F(y,0)\left[e^{-\frac{(x-y)^2}{4\theta}} - e^{-\frac{(x+y)^2}{4\theta}}\right]dy$$

.

In the method above, it is defined

$$F(x,0) \approx F_p(x,0) = \sum_{n=0}a_n x^{n+1}$$

a group of expansion coefficients $a_n$ under 0 K is obtained by polynomial fitting; and therefore

$$F(x,\theta) \approx F_p(x,\theta) = \sum_{n=0}c_n(x,\theta)$$

where $c_n(x, \theta)$ is obtained from a polynomial of the expansion coefficients $a_n$ and $x$ and an error function through four arithmetic operations.

In the method above, the low energy region is less than 10 ev, or less than 5 ev, or less than 1 ev, or less than 0.5 ev, or less than 0.1 ev, or less than 0.05 ev, or less than 0.01 ev.

In the method above, the incident particles are neutrons.

According to another aspect of the present invention, a nuclear cross section Doppler broadening method implemented on a computing device for reducing internal storage needs is provided, where the computing device includes one or more processors and an internal storage; and the method includes executing the method above in the computing device.

In the method above, the processor is a graphics processing unit (GPU).

In the method above, the processor is a neural network chip.

In the method above, the processor is a Field Programmable Logic Gate Array (FPGA).

In the method above, when the method is used for nuclear cross section Doppler broadening of all nuclides in an ENDFB library, all internal storages used in the internal storage are less than 1 G, or less than 800 MB, or less than 500 MB.

According to another aspect of the present invention, a computing device for nuclear cross section Doppler broadening is provided and configured to implement the method above.

In the computing device above, the computing device is one computer; or a plurality of computers for implementing distributed calculation; or a calculation network formed by the plurality of computers.

According to another aspect of the present invention, a reactor Monte Carlo simulation method is provided, which includes: using the method above for nuclear cross section Doppler broadening.

The Doppler broadening method using the cosine sequence is more suitable for directly calculating the reaction cross section of a resolvable resonance region at any energy and temperature. Taking calculating the neutron reaction cross section as an example, all the nuclides in the ENDF database only need hundreds of MBs of data. Moreover, the present invention also provides a low energy correction method in a case of large errors in a low energy region. After experimental verification, it is found that the method of the present invention can calculate most nuclides in the ENDF database, and the transition is smoother on an upper boundary of the energy range. The higher the temperature, the more accurate the calculation result of the present invention.

## Brief Description of the Drawings

The following further describes the preferable embodiments of the present invention in detail with reference to the accompanying drawings, where:

FIG. 1 is a flowchart of a nuclear cross section Doppler broadening method according to an embodiment of the present invention.

FIG. 2 is a schematic diagram of using an ENDF database and an NJOY program to verify the method of the present invention.

FIG. 3A to FIG. 3F exemplarily show experimental results of nuclides 0-18 (MAT-831).

FIG. 4A to FIG. 4F exemplarily show experimental results of U-235 (MAT=9228).

FIG. 5A to FIG. 5F exemplarily show experimental results of U-238 (MAT=9237).

## Detailed Description

To make the objectives, technical solutions, and advantages of the present invention clearer, the following would clearly and completely describe the technical solutions in the embodiments of the present invention with reference to the accompanying drawings in the embodiments of the present invention. Apparently, the described embodiments are merely some rather than all of the embodiments of the present invention. All other embodiments obtained by a person of ordinary skill in the art based on the embodiments of the present invention shall fall within the protection scope of the present invention.

In the following detailed description, reference may be made to each drawings attached to the specification used as part of this application to illustrate particular embodiments of the present invention. In the accompanying drawings, similar reference numerals describe broadly similar components in different drawings. Each specific embodiment of this application is described below in sufficient detail to enable a person of ordinary skills in the art with relevant knowledge and technology to implement the technical solution of this application. It shall be understood that other embodiments may also be used or structural, logical, or electrical changes may be made to the embodiments of this application.

The present invention provides a novel nuclear cross section Doppler broadening method, which enables the nuclear cross section at any energy and temperature to be directly calculated on a computer. In some embodiments, only a few hundred MB of data is required for all nuclides in the ENDF database. In some embodiments, the method of the present invention can reduce the internal storage requirements and better adapt to massively parallel calculation. For the reactor Monte Carlo simulation, the nuclear cross section Doppler broadening method of the present invention also has advantages.

As well known to a person skilled in the art, Doppler broadening is a theory concerning the calculation of the average reaction cross section of the collision between incident particles and target particles of a target material in thermal motion. Assuming that the incident particles have mass m and energy E, and the target particle has mass M and Maxwell distribution at temperature *T*, and then the average reaction cross section $\sigma(E, T)$ can be represented by the following equation:

$$\sigma(E,T) = \frac{1}{x^2}\frac{1}{\sqrt{4\pi\theta}}\int_0^\infty y^2\sigma(E_r,0)\left[e^{-\frac{(x-y)^2}{4\theta}} - e^{-\frac{(x+y^2)}{4\theta}}\right]dy \qquad (1)$$

where $x = \sqrt{E}$, $y = \sqrt{E_r}$ and $y$ are integral variables, and $\theta = mkT/(4M)$; $E_r$ represents energy included by incident particles in a physical reference system in which the target particles are stationary.

Similarly, it is defined that the energy times the average reaction cross section $F(x, \theta)$ as follows:

$$F(x,\theta) = E\sigma(E,T) \qquad (2)$$

then Equation (1) can be represented as:

$$F(x,\theta) = \frac{1}{\sqrt{4\pi\theta}}\int_0^\infty F(y,0)\left[e^{-\frac{(x-y)^2}{4\theta}} - e^{-\frac{(x+y)^2}{4\theta}}\right]dy \qquad (3)$$

For a one-dimensional thermal conduction equation, a target variable $u(x, t)$ thereof describes the temperature at a coordinate space $x$ and time point $t$; $k$ is a thermal diffusion coefficient, and the equation is described as follows:

$$\frac{\partial}{\partial t}u(x,t) = k\frac{\partial^2}{\partial x^2}u(x,t) \qquad (4)$$

$$u(0,t) = 0 \qquad (5)$$

It has a solution based on a Green's equation:

$$u(x,t) = \frac{1}{\sqrt{4\pi kt}}\int_0^\infty u(y,0)\left[e^{-\frac{(x-y)^2}{4kt}} - e^{-\frac{(x+y)^2}{4kt}}\right]dy \qquad (6)$$

Therefore, the solution of the nuclear cross section Doppler broadening can be obtained by solving the one-dimensional thermal conduction equation with respect to $F(x, \theta)$. This thermal conduction equation can be represented as:

$$\frac{\partial}{\partial\theta}F(x,\theta) = \frac{\partial}{\partial x^2}F(x,\theta) \qquad (7)$$

Furthermore, according to properties of physics, the average reaction cross section $\sigma(E,T) = \mathcal{O}(1/\sqrt{E})$

, that is, when $E$ approaches to 0, has a lower order than $1/\sqrt{E}$ ; or when $E$ approaches to 0, $\sqrt{E}\sigma(E,T)$ approaches a constant, which also includes 0. At the same time, also because even for a common constant value in an elastic scattering cross section at $T = 0$ temperature when $E$ approaches to 0, $\sqrt{E}\sigma(E,T)$ approaches to 0. Therefore, when $x$ approaches to 0, $F(x,\theta)$ also approaches to 0.

A person skilled in the art should note that, for a given $F(x, \theta)$, a group of orthogonal functions $g_j(x, \theta)$ are defined, where $j$ is an integer index, which satisfies

$$\int_0^X g_j(x,\theta)g_k(x,\theta)dx = \left\{ \begin{array}{ll} 1 & j = k \\ 0 & j \neq k \end{array} \right.$$

where $X$ is an arbitrarily large upper boundary, then $F(x,\theta)$ can be expanded into

$$F(x,\theta) = \sum_{j=0}^{\infty} g_j(x,\theta)\hat{f}_j(\theta)$$

where $\hat{f}_j(\theta)$ is an expansion coefficient of a positive-valence function, i.e.,

$$\hat{f}_j(\theta) = \int_0^X F(x,\theta)g_j(x,\theta)dx$$

and a differential equation is satisfied:

$$\frac{\partial}{\partial\theta}\left(g_j(x,\theta)\hat{f}(\theta)\right) = \frac{\partial}{\partial x^2}g_j(x,\theta)\hat{f}(\theta)$$

Furthermore, in a case of the given $\hat{f}(0)$, by integrating $x$ from 0 to $X$, solving an equation with respect to $\hat{f}$, and assuming a vanishing boundary condition at $X$, $\hat{f}(\theta)$ can be solved.

In this embodiment, an orthogonal function system of cosine transformation is chosen. Use $F(x,\theta) = F(—x, \theta)$, extend F to the —∞ direction, and make it into an even function, to conduct cosine transformation. A person skilled in the art shall understand that other systems of orthogonal functions may also be applied in a similar manner under the motivation of the cosine transformation of this embodiment. For example, the orthogonal function system can be the orthogonal function system of the Fourier transformation; or the equivalent transformation of the cosine transformation, such as the sine transformation. These are all within the scope of protection of the present invention.

Specifically, for real frequencies $\omega$, the cosine transformation is defined as follows:

$$\hat{f}(\omega,\theta) = \int_0^{\infty} F(x,\theta)\cos(2\pi x\omega)dx \tag{8}$$

Furthermore, multiply Equation (7) by $\cos(2\pi x\omega)$, and integrate $x$ from 0 to ∞, solve the equation about $\hat{f}$, and assume a vanishing boundary condition at ∞, to obtain

$$\hat{f}(\omega,\theta) = \hat{f}(\omega,0)e^{-(2\pi\omega)^2\theta} + \frac{\partial F}{\partial x}(0,0)\frac{e^{-(2\pi\omega)^2\theta} - 1}{(2\pi\omega)^2} \tag{9}$$

For applications on the nuclear cross section Doppler broadening, the boundary condition $\frac{\partial F}{\partial x}(0,0)$ is important at low energies, but can be ignored when being greater than 0.01 reverence, in some embodiments, segmenting processing may be chosen. When being greater than 0.01 ev, the items related to the boundary conditions are ignored. When being less than 0.01 ev, other modes are selected for correction.

Therefore, the $F(x,\theta)$ function is represented as an approximate expression as a cosine sequence:

$$F(x,\theta) \approx \alpha \sum_{j} \hat{f}_j^c(0) e^{-(2\pi\omega_j)^2\theta} \cos(2\pi x \omega_j) \qquad (10)$$

where $\alpha$ is a constant, and a real number $\hat{f}_j^c(0)$ is calculated by multiplying the average reaction cross section at 0 Kelvin temperature by a value of the energy $F(x, 0)$. Moreover, the real number $\omega_j$ is a frequency set that includes discrete frequencies. This expression works for any energy $x$ and temperature $\theta$. The above is a basic idea of this embodiment.

In some embodiments, $\hat{f}_j^c(0)$ coefficients are generated by the discrete cosine transformation to increase a calculation speed of the present invention. As well known to a person skilled in the art, cosine transformations of type II and type III are mappings of $N$ real numbers to other $N$ real numbers:

$$y_k = \alpha_k \sum_{n=0}^{N-1} x_n \cos\left(\pi(n+1/2)k/N\right), \; k = 0, 1, \ldots N-1, \; (\textbf{DCT-II}) \qquad (11)$$

$$x_n = \sum_{k=0}^{N-1} \alpha_k y_k \cos\left(\pi(n+1/2)k/N\right), \; n = 0, 1, \ldots N-1, \; (\textbf{DCT-III}) \qquad (12)$$

where the definition of $\alpha_k$ is:

$$\alpha_k = \begin{cases} 1/\sqrt{N} & k = 0, \\ \sqrt{2/N} & 1 \le k \le N \end{cases} \qquad (13)$$

The cosine transformations of type II and type III are inverse transformation with respect to each other. There is a Fast Fourier Transform (FFT) algorithm based on FFT under the complexity is calculated using $N \log N$. The method of this embodiment can greatly improve the speed of calculation.

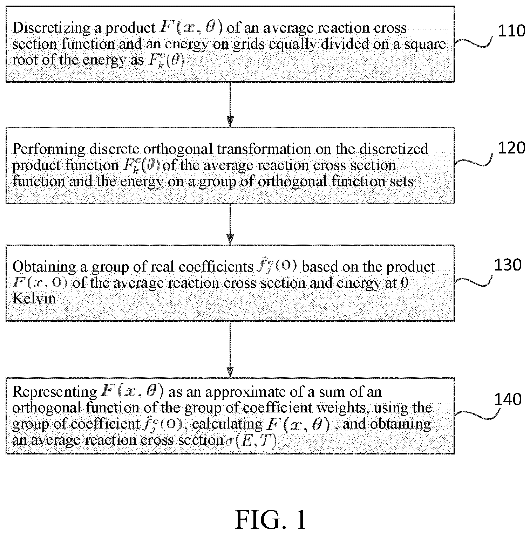

FIG. 1 is a flowchart of a nuclear cross section Doppler broadening method according to an embodiment of the present invention. As shown in FIG. 1, the Doppler broadening method of this embodiment includes the following steps: At Step 110, multiply the average reaction cross section by the energy, i.e., $F(x,\theta)$. discretizing on the grids equally divided on the square root $N$ of the energy. Step 110 relates to the discretization in energy. In some embodiments, a grid that is bisected in the square root of the energy is defined, referred to as X-grid. X-grid has the maximum energy $E_{max}$ and the number of points of the grid is $N$. $N$ It can be an arbitrarily large value. Therefore, the energy at the spot where the grid index is $n$, which can be given by the following equations:

$$e_n = x_n^2 \qquad (14)$$

$$x_n = n\Delta x \qquad (15)$$

$$\Delta x = \sqrt{E_{max}}/(N-1) \qquad (16)$$

$$n = 0, 1, \ldots N-1 \qquad (17)$$

$F(x,\theta)$ would be discretized on the X-grid as:

$$F_k^c(\theta) = F(x_k, \theta), \ k = 0, 1, \ldots N-1 \qquad (18)$$

$$F_0^c(\theta) = F(0, \theta) = 0 \qquad (19)$$

At Step 120, the discretized average reaction cross section is multiplied by the energy $F_k^c(\theta)$ into a group of orthogonal functions for the discrete orthogonal transformation. Step 120 relates to the discretization in orthogonal function index. As mentioned above, this group of orthogonal functions, i.e., the orthogonal function system, is chosen as a cosine change function system. At this time, Step 120 relates to the discretization in cosine function frequency domain. Of course, as mentioned earlier, other of orthogonal function systems are also possible.

For the convenience of calculation, we choose a frequency set $\omega_j = \dfrac{2j+1}{4N\Delta x}$ of real numbers as the frequency of the cosine function, and at this time, the coefficient $\hat{f}_j^c(\theta)$ of the discrete cosine transformation of $F_k^c(\theta)$ is given by the following equation:

$$\hat{f}_j^c(\theta) = \sum_{k=0}^{N-1} F_k^c(\theta) \cos(2\pi\omega_j x_k)\Delta x, \ j = 0, 1, \ldots N-1 \qquad (20)$$

At Step 130, a group of real coefficients $\hat{f}_j^c(0)$ are obtained based on the product $F(x, 0)$ of the average reaction cross section and energy at 0 Kelvin.

In some implementation examples, it is obtained in the following way $\hat{f}_j^c(0)$ : first, the product $F_k^c(0)$ of the discrete average reaction cross section and energy at 0 Kelvin temperature is calculated, and then the type III discrete cosine transform is applied to $F_k^c(0)$ , and the following equation would be given:

$$\begin{pmatrix} \vdots \\ F_k^c(0)\Delta x \\ \vdots \end{pmatrix} \xrightarrow{\text{DCT-III}} \begin{pmatrix} \sum_{k=0}^{N-1} \alpha_k F_k^c(0)\Delta x \cos(\frac{\pi k(1)}{2N}) \\ \vdots \\ \sum_{k=0}^{N-1} \alpha_k F_k^c(0)\Delta x \cos(\frac{\pi k(2j+1)}{2N}) \\ \vdots \end{pmatrix}$$

$$= \begin{pmatrix} \sqrt{\frac{2}{N}}\hat{f}_0^c(0) \\ \vdots \\ \sqrt{\frac{2}{N}}\hat{f}_j^c(0) \\ \vdots \end{pmatrix} + \frac{1-\sqrt{2}}{\sqrt{N}} F_0^c(0)\Delta x \begin{pmatrix} \vdots \\ 1 \\ \vdots \end{pmatrix} = \begin{pmatrix} \sqrt{\frac{2}{N}}\hat{f}_0^c(0) \\ \vdots \\ \sqrt{\frac{2}{N}}\hat{f}_j^c(0) \\ \vdots \end{pmatrix}$$

According to Equation (9), and ignoring the boundary conditions at $x = 0$, and it is observed that $\hat{f}^c$ is the following approximation of $\hat{f}$:

$$\hat{f}(\omega_j, \theta) = \int_0^\infty F(x, \theta) \cos(2\pi x \omega_j) dx$$

$$\approx \sum_{k=0}^{N-1} F_k^c(\theta) \Delta x \cos(2\pi x_k \omega_j)$$

$$= \hat{f}_j^c(\theta) \qquad (22)$$

The function between $\hat{f}_j^c(\theta)$ and $\hat{f}_j^c(0)$ can be established in the following mode:

$$\hat{f}_j^c(\theta) \approx \hat{f}_j^c(0) e^{-(2\pi\omega_j)^2\theta} \qquad (23)$$

Multiply the $\hat{f}$ item in Equation (21) by $e^{-(2\pi\omega j)2\theta}$ and perform the type II discrete cosine transformation, to obtain the approximate of the discretization value $F_k^c(\theta)$ of the product of the average reaction cross section and energy at temperature $\theta$:

$$\begin{pmatrix} \sqrt{\frac{2}{N}} \hat{f}_0^c(0) e^{-(2\pi\omega_0)^2\theta} \\ \vdots \\ \sqrt{\frac{2}{N}} \hat{f}_j^c(0) e^{-(2\pi\omega_j)^2\theta} \\ \vdots \end{pmatrix} \xrightarrow{\text{DCT-II}} \begin{pmatrix} \vdots \\ \tilde{F}_k^c(\theta) \Delta x \\ \vdots \end{pmatrix} \qquad (24)$$

where $\tilde{F}_k^c(\theta) \approx F_k^c(\theta)$, i.e., $\tilde{F}_k^c(\theta)$ equals about to $F_k^c(\theta)$.

The content above is summarized through an algorithm in Table 1 below, so as to facilitate the understanding of a person skilled in the art:

---
**Algorithm 1** Doppler Broadening using DCT

---
**Require:** $N, \Delta x, \theta, F_k^c(0)\ (k = 0, 1, \ldots N - 1)$
**Ensure:** $\hat{f}_j^c(0), \tilde{F}_k^c(\theta)\ (k = 0, 1, \ldots N - 1)$

    Let $\{G_j\} = $DCT-III$(\{F_k^c(0)\})$

    Set $\{\hat{f}_j^c(0)\} = \{\Delta x \sqrt{\frac{N}{2}} G_j\}$

    Set $\{F_k^c(\theta)\} = $DCT-II$(\{G_j \exp(-(2\pi \frac{2j+1}{4N\Delta x})^2\theta)\})$

---

At Step 140, represent $F(x, \theta)$ as a similarity of a sum of an orthogonal function of the group of coefficient weights, use the group of coefficient weights, compute $F(x, \theta)$, and obtain an average reaction cross section $\sigma(E, T)$.

In some embodiments, when the orthogonal transformation is the cosine transformation, according to Equation (24), $F_k^c(\theta)$ can be approximated by the sum of $\hat{f}_j^c(0)$ sequences with weights:

$$F_k^c(\theta) \approx \tilde{F}_k^c(\theta) = \frac{\alpha_k}{\Delta x}\sqrt{\frac{2}{N}}\sum_{j=0}^{N-1}\hat{f}_j^c(0)e^{-(2\pi\omega_j)^2\theta}\cos(2\pi x_k\omega_j)$$

$$= \begin{cases} \frac{1}{\Delta x}\frac{2}{N}\sum_{j=0}^{N-1}\hat{f}_j^c(0)e^{-(2\pi\omega_j)^2\theta}\cos(2\pi x_k\omega_j) & k\geq 1 \\ \frac{1}{\Delta x}\frac{\sqrt{2}}{N}\sum_{j=0}^{N-1}\hat{f}_j^c(0)e^{-(2\pi\omega_j)^2\theta} & k=0 \end{cases} \qquad (25)$$

The approximation shows that $F(x,\theta)$ is a cosine sequence approximation:

$$F(x,\theta) \approx \frac{1}{\Delta x}\frac{2}{N}\sum_{j=0}^{N-1}\hat{f}_j^c(0)e^{-(2\pi\omega_j)^2\theta}\cos(2\pi x\omega_j) \qquad (26)$$

As mentioned above, when the energy $E$, that is, $x^2$, approaches to 0, the average reaction cross section $\sigma(E, T)$ would form the shape of $1/\sqrt{E}$ or $1/x$, or approaches a constant, so that when $x$ approaches to 0, the product $F(x,\theta)$, i.e., $E\sigma(E, T)$, of the average reaction cross section and the energy also approaches to 0. Hence, when $x = 0$, $F(0, \theta) = 0$.

In some implementations, for $\hat{f}_j^c$ of $j$ having a relatively large index, i.e., the high frequency part, the influence is quite small. Therefore, only $N_{sparse}$ items in front of Equation (26) can be taken, that is, multiple sparse items in front, where $N_{sparse}$ is less than $N$, for example, $N_{sparse}$ is within 10% of $N$:

$$F(x,\theta) \approx \frac{1}{\Delta x}\frac{2}{N}\sum_{j=0}^{N_{sparse}-1}\hat{f}_j^c(0)e^{-(2\pi\omega_j)^2\theta}\cos(2\pi x\omega_j) \qquad (27)$$

According to the inventor's verification, for the calculation of Doppler broadening of the nuclear cross section, only a small number of $N_{sparse}$ items can be calculated to meet the precision requirements of the Doppler broadening calculation. In some embodiments, $N_{sparse}$ is less than 500,000; or $N_{sparse}$ is less than 1,000,000. Therefore, such truncation can greatly improve the calculation speed of the present invention.

In some embodiments, $N_{sparse}$ is determined according to a predetermined precision threshold. For example, the predetermined precision threshold can be 0.001; that is to say, if the nuclear cross section of all N items are reserved as standard at a certain temperature, then the maximum difference between the nuclear cross sections obtained by calculating the previous $N_{sparse}$ items and the nuclear cross section as the standard at any energy point is less than 0.001, then $N_{sparse}$ at this time is the required number of reserved items. After truncation, the item after the preceding $N_{sparse}$ items can be omitted.

In some implementations, the predetermined precision threshold is represented by a maximum value in absolute values of relative errors at an energy grid point $e_k$ of a reserving $N$ item and a reserving $N_{sparse}$ item in $F(x,\theta)$ expansion, where $k = 0,1, ... N - 1$; and where the predetermined precision threshold is less than or equal to 0.001, i.e.,

$$\max_{0\leq k\leq N-1}\left|\frac{\sigma_k^{N_{sparse}}(\theta)-\sigma_k^{N}(\theta)}{\sigma_k^{N}(\theta)}\right| \leq 0.001$$

where

$$\sigma_k^{N_{sparse}}(\theta) = \frac{1}{x_k^2}\frac{1}{\Delta x}\frac{2}{N}\sum_{j=0}^{N_{sparse}-1}\hat{f}_j^c(0)e^{-(2\pi\omega_j)^2\theta}\cos(2\pi x_k\omega_j)$$

$$\sigma_k^N(\theta) = \frac{1}{x_k^2} \frac{1}{\Delta x} \frac{2}{N} \sum_{j=0}^{N-1} \hat{f}_j^c(0) e^{-(2\pi\omega_j)^2\theta} \cos(2\pi x_k \omega_j)$$

.

Furthermore, as shown in Equation (27), at higher temperatures, the high frequency coefficient (the greater index 7) approaches to 0 faster than the low frequency coefficient (the smaller index J). Therefore, the higher the temperature, the more accurate the solution of the present invention. For the preset temperature range concerned by the user, the predetermined precision threshold may be a precision threshold corresponding to a lower limit of the preset temperature range.

A person skilled in the art should note that $\hat{f}_j(0)$ is obtained by type III discrete cosine transformation in the algorithm of Table 1 and reserving the previous $N_{sparse}$ item compression. When the $\hat{f}_j(0)$ coefficient is obtained, the Doppler broadening of the nuclear cross section at any energy and temperature can be directly calculated.

The content above is summarized through an algorithm in Table 2 below, so as to facilitate the understanding of a person skilled in the art:

---

**Algorithm 2** Doppler Broadening using Cosine Series Expansion

---

**Require:** $N, N_{sparse}, \Delta x, x, \theta, \hat{f}_j^c(0), (j = 0, 1, \dots N_{sparse} - 1)$

**Ensure:** $\tilde{F}(x, \theta) \, (k = 0, 1, \dots N - 1)$

Let $\omega_j = (2j + 1)/(4N\Delta x)$

Set $\tilde{F}(x, \theta) = \frac{1}{\Delta x} \frac{2}{N} \sum_{j=0}^{N_{sparse}-1} \hat{f}_j^c(0) \exp(-(2\pi\omega_j)^2\theta) \cos(2\pi x\omega_j))$

---

As stated above, for the low energy, for example, less than 10 ev, or less than 5 ev, or less than 1 ev, or less than 0.5 ev, or less than 0.1 ev, or less than 0.05 ev, in particular, less than 0.01 ev, the nuclear reaction interface calculated by Equation (27) has errors. Hence, the present invention further provides a low energy correction mode. For example, using $F(x, 0)$ below 0 Kelvin, the energy cross section function at any temperature at low energy can be calculated based on Equation (3) as follows:

$$F(x, \theta) = \frac{1}{\sqrt{4\pi\theta}} \int_0^\infty F(y, 0) \left[ e^{-\frac{(x-y)^2}{4\theta}} - e^{-\frac{(x+y)^2}{4\theta}} \right] dy$$

In some embodiments, it is defined:

$$F(x, 0) \approx F_p(x, 0) = \sum_{n=0} a_n x^{n+1} \qquad (28)$$

Use the polynomial of $x$ to fit $F(x, 0)$, so as to obtain a group of expansion coefficients $a_n$ at 0 Kelvin. Hence, Doppler broadening to a $\theta$ value proportional to temperature T, to obtain

$$F(x, \theta) \approx F_p(x, \theta) = \sum_{n=0} c_n(x, \theta) \qquad (29)$$

where $c_n(x, \theta)$ is the contribution from item $a_n x^{n=1}$; and it can be expressed as the closed expression of the expansion coefficient $a_n$ and the polynomial of $x$ and an error function (erf) obtained by four arithmetic operations of addition, subtraction, multiplication, and division. The calculation of $c_n(x, \theta)$ is illustrated by a few specific examples.

defines $\tilde{x} = x/\sqrt{4\theta}$. For example, taking $n = 0, 1, 2, 3, 4, 5$ as an example, based on Equation (3), $c_n(x, \theta)$ can be given by the following formula:

$$c_0(x,\theta) = a_0 \frac{1}{\sqrt{\pi}}(\sqrt{4\theta})\left[\sqrt{\pi}\tilde{x}\right]$$

$$c_1(x,\theta) = a_1 \frac{1}{\sqrt{\pi}}(\sqrt{4\theta})^2 \left[\frac{1}{2}\sqrt{\pi}(2\tilde{x}^2+1)\mathrm{erf}(\tilde{x})\right]$$

$$c_2(x,\theta) = a_2 \frac{1}{\sqrt{\pi}}(\sqrt{4\theta})^3 \left[\frac{1}{2}\sqrt{\pi}\tilde{x}(2\tilde{x}^2+3)\right]$$

$$c_3(x,\theta) = a_3 \frac{1}{\sqrt{\pi}}(\sqrt{4\theta})^4 \left[\frac{1}{4}\sqrt{\pi}(4(\tilde{x}^2+1)\tilde{x}^2+3)\mathrm{erf}(\tilde{x})\right.$$
$$\left. +\frac{1}{2}e^{-\tilde{x}^2}\tilde{x}(2\tilde{x}^2+5)\right]$$

$$c_4(x,\theta) = a_4 \frac{1}{\sqrt{\pi}}(\sqrt{4\theta})^5 \left[\frac{1}{4}\sqrt{\pi}\tilde{x}(4(\tilde{x}^2+5)\tilde{x}^2+15)\right]$$

$$c_5(x,\theta) = a_5 \frac{1}{\sqrt{\pi}}(\sqrt{4\theta})^6 \left[\frac{1}{8}\sqrt{\pi}(8\tilde{x}^6+60\tilde{x}^4+90\tilde{x}^2+15)\mathrm{erf}(\tilde{x})\right.$$
$$\left. +\frac{1}{4}e^{-\tilde{x}^2}\tilde{x}(4\tilde{x}^4+28\tilde{x}^2+33)\right]$$

Experimental verification of the present invention

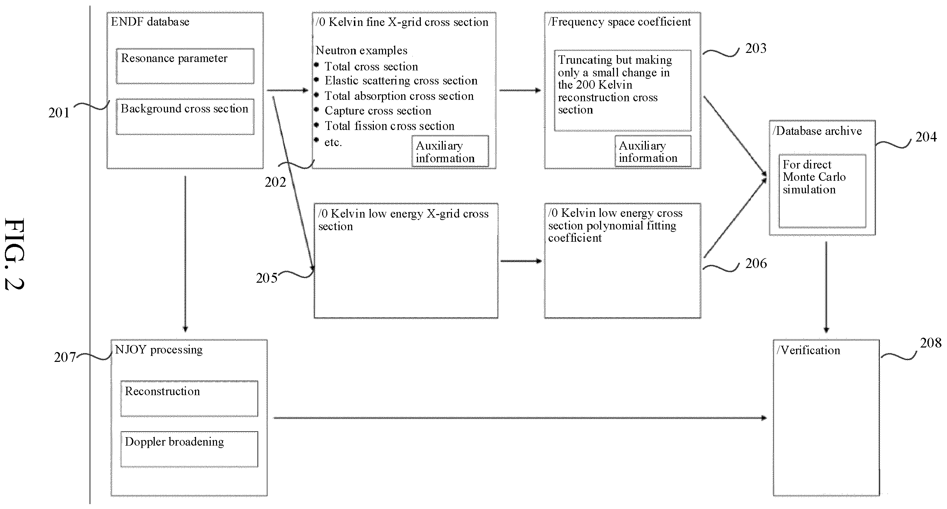

FIG. 2 is a schematic diagram of using an ENDF database and an NJOY program to verify the method of the present invention. The ENDF/B-VIII.0 database 201 is shown in the upper left of FIG. 2. As is well known to a person skilled in the art, the ENDF/B-VIII.0 database includes file 2, which stores usage parameters of most nuclides and represents the distinguishable resonance cross sections (the resonance parameters), and file 3, which stores the background cross section. In the database, there are three ways to express the resolvable resonance cross section parameters: MLBW (Multilevel Breit-Wigner), RM (Reich-Moore), and RML (R-Matrix Limited). In this experiment, 448 nuclides expressed by means of MLBW and RM are used for testing. Of course, the method of the present invention can also be applied to nuclides expressed in other modes.

Taking the neutron transport calculation as an example, the total cross section (MT=1), elastic scattering cross section (MT=2), total absorption cross section (MT=27), capture cross section (MT=102), and total fission cross section (MT=18) are used for verification. In this experiment, at Step 202, a frequency space coefficient $\hat{f}_j^c(0)$ is calculated by using the discretization cross section $F_k^c(0)$ of $F(x,0)$ at 0 K in the fine $X$-grid, and the product $F(x,\theta)$ of the average reaction cross section and energy at temperature $\theta$ is calculated by using Equation (27). The target temperature is from 200 K to 3000 K with a temperature lower limit of 200 K. Reconr and Broadr subroutines in NJOY2016 program are used as comparison standards, and a fault tolerance rate is set as 0.00001 (1E-5). Therefore, $N_{sparse}$ is determined since the nuclear cross section difference calculated at 200 K meets the fault tolerance rate, and the tried fault tolerance rate is 0.001 (1E-3).Furthermore, at Step 204, the cross section of the low energy region (less than 0.01 ev) at 0 Kelvin is fitted by polynomial. At Step 205, it is expanded to arbitrary temperatures. Then, processing results of both low and high energy regions are stored in the database at Step 206.

In order to verify the method of the present invention, the Reconr and Broadr subroutines in the NJOY2016 program 207 are used and the fault tolerance rate is set to 0.00001 (1E-5). In the art, the value of a common fault tolerance rate is 0.001 (1E-3). In this experiment, two orders of magnitude lower are used for detecting any difference except the numerical errors. The energy points on the total cross section energy grid obtained by NJOY are used for verifying the calculation results of the present invention to compare the closeness degree of the cross section values at different energy points. Furthermore, the total cross section, elastic scattering cross section, total absorption cross section, capture cross section, and total fission cross section are obtained by using a post-processing mode.

In step 208, the results of the method of the present invention stored in the database are compared with the results obtained by NJOY to verify the method of the present invention. The method of the present invention is verified for the total cross section, elastic scattering cross section, capture cross section, total absorption cross section, and total fission cross section (if any) in the temperature range of 200 to 3000 K. As shown, the low energy correction method proposed in the present invention is partially used at low energy.

Experimental Results:

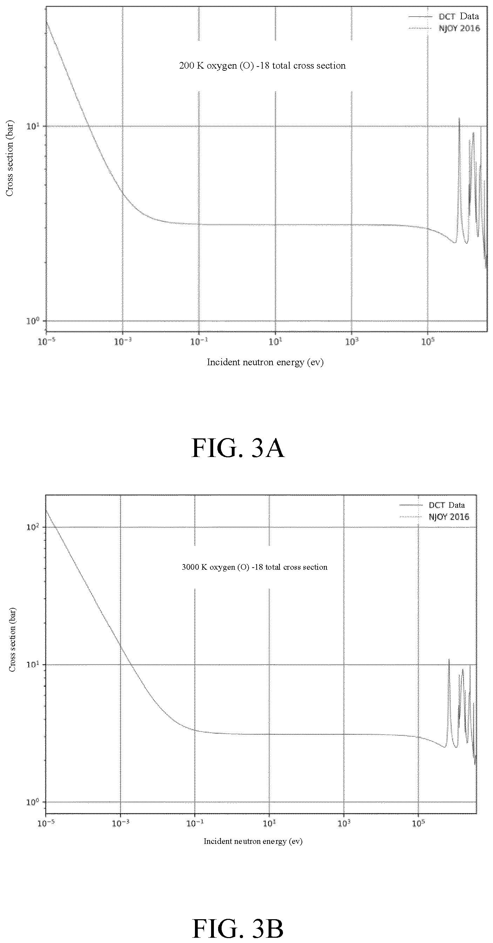

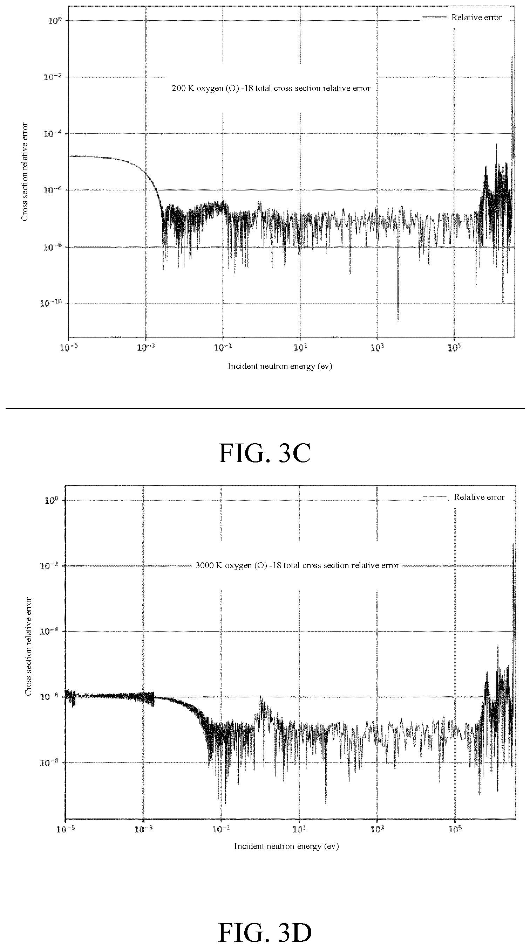

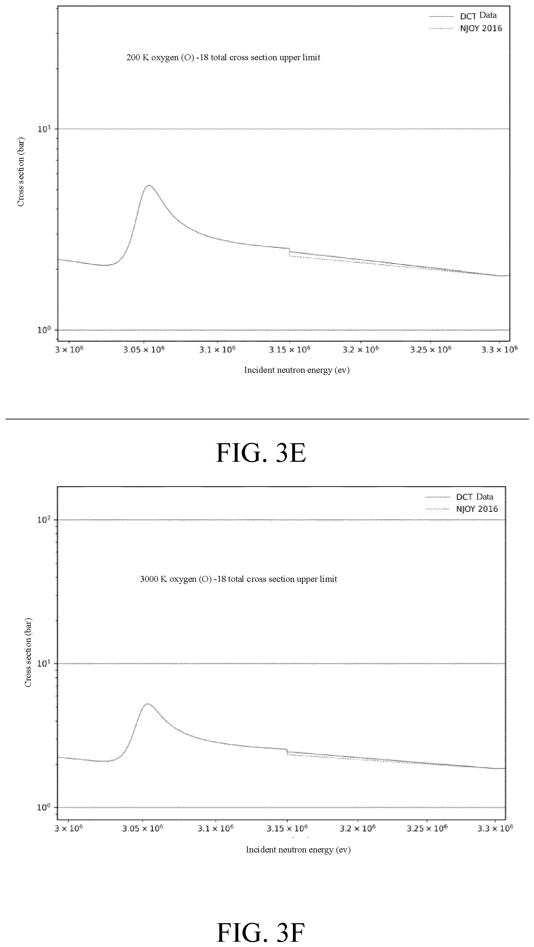

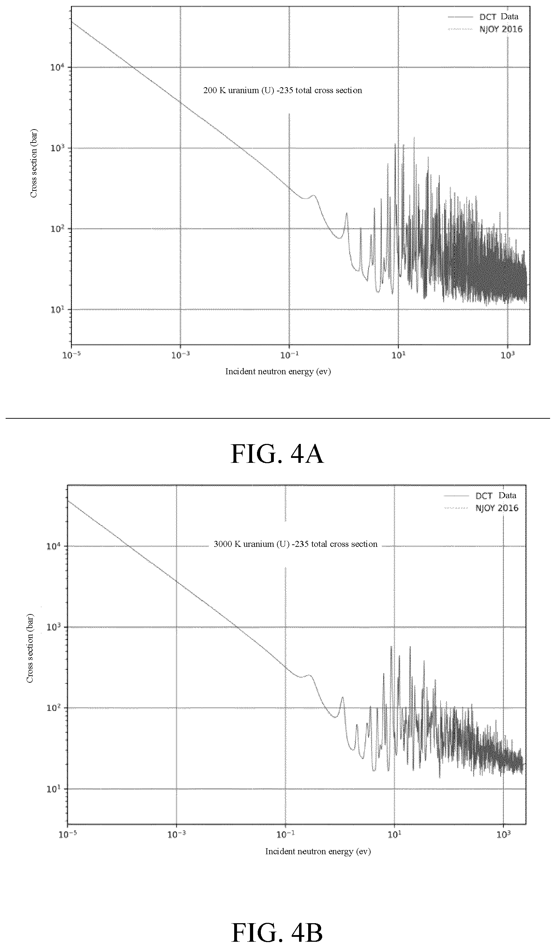

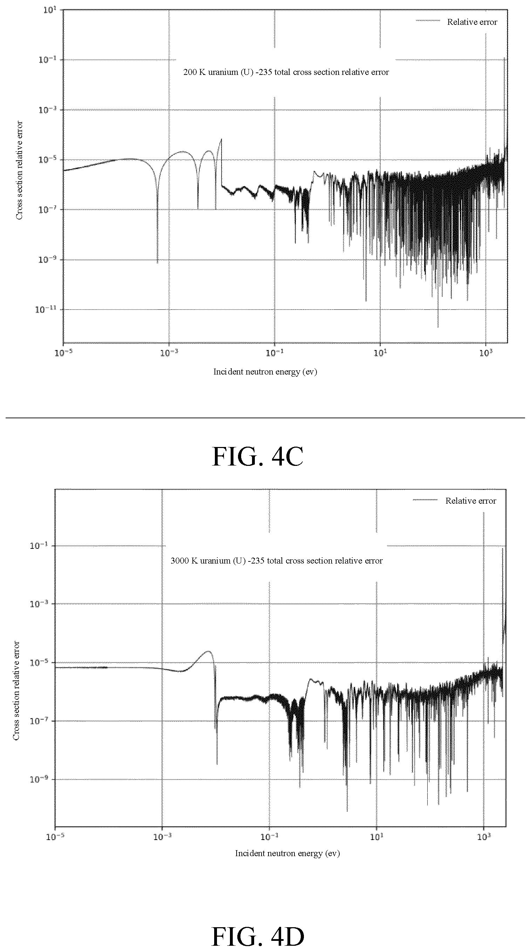

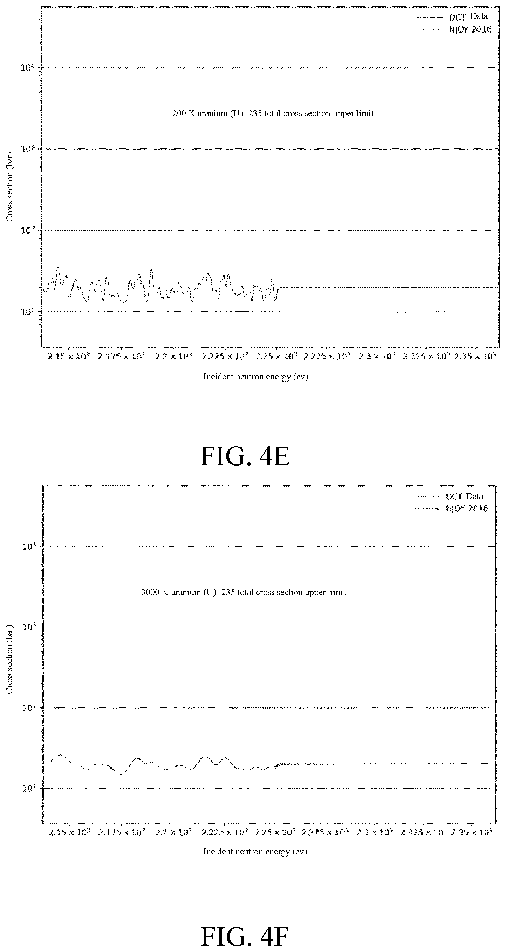

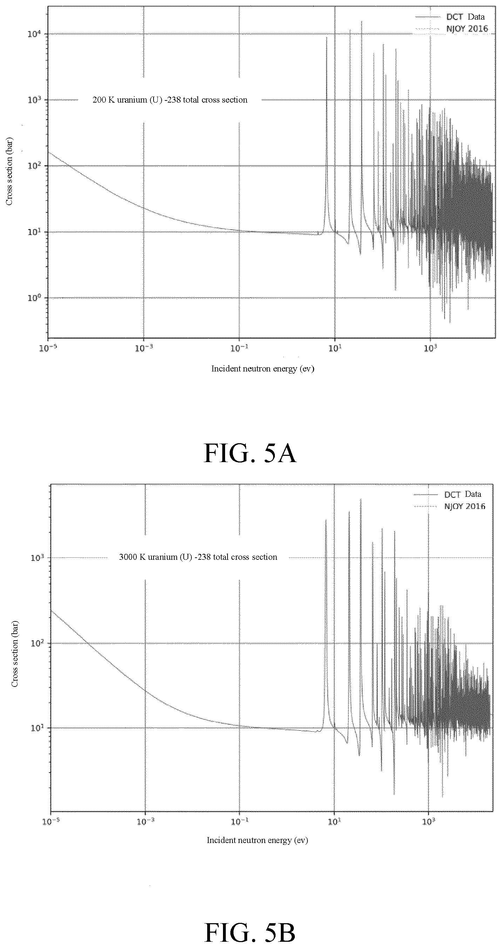

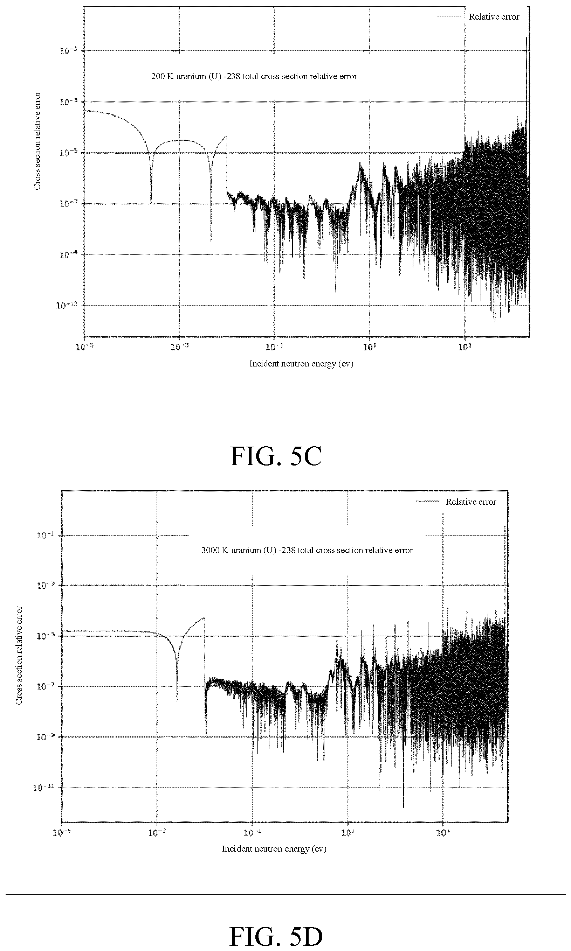

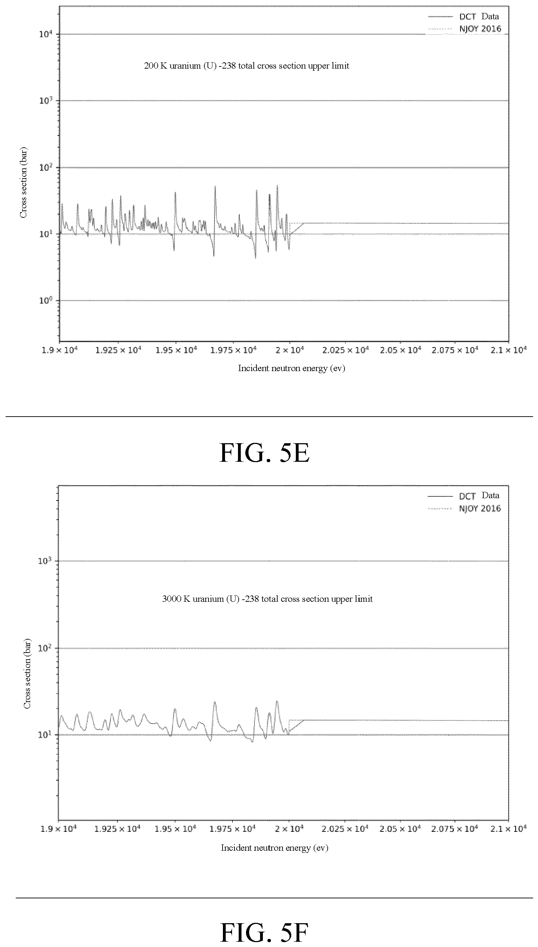

Through the method above, 448 nuclides in the ENDF/B-VIII.0 database are verified. FIG. 3A to FIG. 3F, FIG. 4A to FIG. 4F, and FIG. 5A to FIG. 5F exemplarily show experimental results of nuclides 0-18 (MAT-831), U-235 (MAT=9228), and U-238 (MAT=9237), respectively. The relative error of the nuclear cross section $\sigma$ with respect to $\sigma$ is defined as:

$$\epsilon_{rel} = \left| \frac{\sigma - \sigma_0}{\sigma_0} \right| \qquad (30)$$

where $\epsilon_{rel}$ represents the relative error, $\sigma$ is the result calculated using the method above, and $\sigma_0$ represents the calculation result of NJOY.

Through the experiments above, the maximum relative error of 448 nuclides in total with respect to the calculation result of NJOY is only 0.001. At the same time, it is better than this error index most of the time. Moreover, the inventor notes that at the upper boundary of the energy range, the method of the present invention makes the transition of the boundary smoother. However, the transition of NJOY's algorithm is discontinuous, which makes it seem that there is a large error at the boundary.

As shown in Equation (27), at higher temperatures, the high frequency coefficient (the greater index *j*) approaches to 0 faster than the low frequency coefficient (the smaller index J), which would make the curve smoother. Moreover, the experimental results also show that the higher the temperature, the more accurate the solution of the present invention.

Through the experiments above, the Doppler broadening method using the cosine sequence is more suitable for directly calculating the reaction cross section of a resolvable resonance region at any energy and temperature. Taking calculating the neutron reaction cross section as an example, all the nuclides in the ENDF database only need hundreds of MBs of data. Moreover, the present invention also provides a low energy correction method in a case of large errors in a low energy region. After experimental verification, it is found that the method of the present invention can calculate most nuclides in the ENDF database, and the transition is smoother on an upper boundary of the energy range. The higher the temperature, the more accurate the calculation result of the present invention.

As understood by a person skilled in the art and verified by the experiments above, the method of the present invention can realize the Doppler broadening of the nuclear cross section when the incident particles are neutrons. Considering that the electromagnetic force has little influence on the nuclear reaction, the Doppler broadening method of the present invention can also be applied to other particles, not limited to neutrons.

The present invention also provides a nuclear cross section Doppler broadening method implemented on a computing device for reducing internal storage needs is provided, where the computing device includes one or more processors and an internal storage. The computing device is used for performing the nuclear cross section Doppler broadening method of the present invention as illustrated in the embodiment above. The computing device is one computer; or a plurality of computers for implementing distributed calculation; or a calculation network formed by the plurality of computers. As mentioned above, the nuclear cross section Doppler broadening method of the present invention can greatly reduce the internal storage usage amount and reduce the internal storage requirement, and the internal storage used for the nuclear cross section Doppler broadening of all nuclides in the ENDF/B-VIII.0 nuclear database is less than 1 G, or less than 800 MB, or less than 500 MB; it should be understood by a person skilled in the art that the present invention is not limited to the ENDF/B-VIII.0 version of the nuclear database. Moreover, the method of the present invention can be carried out at a faster speed. Furthermore, the method of the present invention is also more suitable for parallel calculation. Therefore, the processor of the computing device is also a processor suitable for parallel calculation, so as to perform Doppler broadening of the nuclear cross section faster.

In some embodiments, the processor of the computing device is a graphics processing unit (GPU), for example, a neural network chip. More specifically, the processor is a Field Programmable Logic Gate Array (FPGA). The method of the present invention can be more efficient by using a GPU and other processing chips for calculation. This is also a preferred implementation of the present invention.

As an application of the present invention, the present invention also provides a reactor Monte Carlo simulation method, which includes: using the nuclear cross section Doppler broadening method exemplified in the embodiments above.

The embodiments above are only for the purpose of explaining the present invention and are not limitations to the present invention. A person of ordinary skills in the relevant technical field can also make various changes and variations without departing from the scope of the present invention. Therefore, all equivalent technical solutions shall also belong to the scope disclosed by the present invention.

**Claims**

1. A nuclear cross section Doppler broadening method, comprising:

   discretizing a product $F(x, \theta)$ of an average reaction cross section function $\sigma(E, T)$ and an energy $E$ on grids equally divided on a square root $N$ of the energy as $F_k^c(\theta)$, wherein incident particles have mass $m$ and energy $E$, target particles have mass $M$ and Maxwellian energy distribution under a temperature $T$, and $F(x, \theta) = E\sigma(E, T)$, $F_k^c(\theta) = F(x_k, \theta)$, $k = 0, 1, \ldots N - 1$, $x = \sqrt{E}$, and $c$ are discrete superscript symbols;

   expanding the product $F(x, \theta)$ of the average reaction cross section function and the energy on a group of orthogonal function sets, an expansion coefficient being $\hat{f}_j(\theta)$, and $j$ being an index of the orthogonal function sets, wherein for the discretized product $F_k^c(\theta)$ of the average reaction cross section function and the energy, an orthogonal function expansion coefficient thereof is $\hat{f}_j^c(\theta) \approx \hat{f}_j(\theta)$;

   based on the product $F(x, 0)$ of the average reaction cross section function and the energy under a 0 K temperature, obtaining a group of coefficient weights $\hat{f}_j^c(0)$, wherein $\hat{f}_j^c(\theta)$ is a function of $\hat{f}_j^c(0)$; and

   representing $F(x, \theta)$ as a sum of an orthogonal function of the group of coefficient weights, using the group of coefficient weights $\hat{f}_j^c(\theta)$, calculating $F(x, \theta)$, and obtaining an average reaction cross section $\sigma(E, T)$.

2. The method according to claim 1, wherein for the grids equally divided on the square root of the energy, a size of the grid is $N$, a maximum energy point is a grid point $E_{max}$, and an energy at a spot where a grid index is $n$ is $e_n$, meeting the following condition:

$$e_n = x_n^2$$

$$x_n = n\Delta x$$

$$\Delta x = \sqrt{E_{max}}/(N-1)$$

$$n = 0, 1, \ldots N - 1. \quad ;$$

   wherein $F(x, \theta)$ is discretized on the grids equally divided on the square root $N$ of the energy:

$$F_k^c(\theta) = F(x_k, \theta), \quad k = 0, 1, \ldots N - 1,$$

$$F_0^c(\theta) = F(0, \theta) = 0.$$

3. The method according to claim 1, further comprising: performing orthogonal transformation on the product $F(x, \theta)$ of the average reaction cross section function and the energy; and performing discrete orthogonal transformation on the discretized product $F_k^c(\theta)$ of the average reaction cross section function and the energy.

4. The method according to claim 3, further comprising: Performing Fourier transform on the product $F(x, \theta)$ of the average reaction cross section function and the energy; and performing discrete Fourier transformation on the discretized product $F_k^c(\theta)$ of the average reaction cross section function and the energy.

5. The method according to claim 3, further comprising: performing cosine transformation or equivalent transformation of the cosine transformation on the product $F(x, \theta)$ of the average reaction cross section function and the energy; and performing discrete cosine transformation or equivalent transformation of the discrete cosine transformation on the discretized product $F_k^c(\theta)$ of the average reaction cross section function and the energy.

6. The method according to claim 5, wherein a basis for the cosine transformation is $\cos(2\pi\omega_j x)$, and a frequency thereof is $\omega_j = \dfrac{2j+1}{4N\Delta x}$, then

$$\hat{f}_j(\theta) = \int_0^{N\Delta x} F(x, \theta) \cos(2\pi x \omega_j) dx \ ;$$

a basis for the discrete cosine transformation is $\cos(2\pi\omega_j x_k)$, then

$$\hat{f}_j^c(\theta) = \sum_{k=0}^{N-1} F_k^c(\theta) \cos(2\pi\omega_j x_k) \Delta x \ ;$$

wherein $j = 0, 1, ... N - 1$ is an integer; and

wherein a function relation between $\hat{f}_j^c(\theta)$ and $\hat{f}_j^c(0)$ is:

$$\hat{f}_j^c(\theta) \approx \hat{f}_j^c(0) e^{-(2\pi\omega_j)^2 \theta} \ .$$

7. The method according to claim 6, wherein when the orthogonal transformation is the cosine transformation, $F(x, \theta)$ is represented as a sum of an orthogonal function of the group of coefficient weights as follows:

$$F(x, \theta) \approx \frac{1}{\Delta x} \frac{2}{N} \sum_{j=0}^{N-1} \hat{f}_j^c(0) e^{-(2\pi\omega_j)^2 \theta} \cos(2\pi x \omega_j) \ .$$

8. The method according to claim 7, wherein only first $N_{sparse}$ sparse items in $F(x, \theta)$ expansion are reserved:

$$F(x, \theta) \approx \frac{1}{\Delta x} \frac{2}{N} \sum_{j=0}^{N_{sparse}-1} \hat{f}_j^c(0) e^{-(2\pi\omega_j)^2 \theta} \cos(2\pi x \omega_j) \ ;$$

wherein $N_{sparse}$ is less than $N$.

9. The method according to claim 8, wherein based on a predetermined precision threshold, $N_{sparse}$ is determined.

10. The method according to claim 9, wherein the predetermined precision threshold is represented by a maximum value in absolute values of relative errors at an energy grid point $e_k$ of a reserving $N$ item and a reserving $N_{sparse}$ item in $F(x, \theta)$ expansion, wherein $k = 0,1, ... N - 1$; and wherein the predetermined precision threshold is less than or equal to 0.001, i.e.,

$$\max_{0 \le k \le N-1} \left| \frac{\sigma_k^{N_{sparse}}(\theta) - \sigma_k^N(\theta)}{\sigma_k^N(\theta)} \right| \le 0.001$$

wherein

$$\sigma_k^{N_{sparse}}(\theta) = \frac{1}{x_k^2} \frac{1}{\Delta x} \frac{2}{N} \sum_{j=0}^{N_{sparse}-1} \hat{f}_j^c(0) e^{-(2\pi\omega_j)^2\theta} \cos(2\pi x_k \omega_j)$$

$$\sigma_k^N(\theta) = \frac{1}{x_k^2} \frac{1}{\Delta x} \frac{2}{N} \sum_{j=0}^{N-1} \hat{f}_j^c(0) e^{-(2\pi\omega_j)^2\theta} \cos(2\pi x_k \omega_j) \quad .$$

11. The method according to claim 8, wherein $N_{sparse}$ is less than 500,000, or less than 1,000,000.

12. The method according to claim 10, wherein the predetermined precision threshold is a precision threshold corresponding to a lower limit of a preset temperature range.

13. The method according to claim 12, wherein the lower limit of the preset temperature range is 200 K.

14. The method according to claim 1, wherein in a lower energy region, $F(x,0)$ of 0 K is used, and $F(x,\theta)$ is calculated based on the following formula:

$$F(x, \theta) = \frac{1}{\sqrt{4\pi\theta}} \int_0^\infty F(y, 0) \left[ e^{-\frac{(x-y)^2}{4\theta}} - e^{-\frac{(x+y)^2}{4\theta}} \right] dy \quad .$$

15. The method according to claim 14, wherein it is defined

$$F(x, 0) \approx F_p(x, 0) = \sum_{n=0} a_n x^{n+1}$$

a group of expansion coefficients $a_n$ under 0 K is obtained by polynomial fitting; and then

$$F(x, \theta) \approx F_p(x, \theta) = \sum_{n=0} c_n(x, \theta)$$

wherein $c_n(x,\theta)$ is obtained from a polynomial of the expansion coefficients $a_n$ and $x$ and an error function through four arithmetic operations.

16. The method according to claim 13, wherein the low energy region is less than 10 ev, or less than 5 ev, or less than 1 ev, or less than 0.5 ev, or less than 0.1 ev, or less than 0.05 ev, or less than 0.01 ev.

17. The method according to claim 1, wherein the incident particles are neutrons.

18. A nuclear cross section Doppler broadening method implemented on a computing device for reducing internal storage needs, wherein the computing device comprises one or more processors and an internal storage; and the method comprises executing the method according to any one of claims 1 to 17 in the computing device.

19. The method according to claim 18, wherein the processor is adapted to parallel calculation for nuclear cross section Doppler broadening.

20. The method according to claim 18, wherein the processor is a graphics processing unit (GPU).

21. The method according to claim 18, wherein the processor is a neural network chip.

22. The method according to claim 18, wherein the processor is a Field Programmable Logic Gate Array (FPGA).

23. The method according to claim 18, wherein when the method is used for nuclear cross section Doppler broadening of all nuclides in an ENDFB library, all internal storages used in the internal storage are less than 1 G, or less than 800 MB, or less than 500 MB.

24. A computing device for nuclear cross section Doppler broadening, configured to implement the method according to any one of claims 18 to 22.

25. The computing device according to claim 24, wherein the computing device is a computer; or a plurality of computers for implementing distributed calculation; or a calculation network formed by the plurality of computers.

26. A reactor Monte Carlo simulation method, comprising using the method according to any one of claims 1 to 18 for nuclear cross section Doppler broadening.

Discretizing a product $F(x, \theta)$ of an average reaction cross section function and an energy on grids equally divided on a square root of the energy as $F_k^c(\theta)$     110

Performing discrete orthogonal transformation on the discretized product function $F_k^c(\theta)$ of the average reaction cross section function and the energy on a group of orthogonal function sets     120

Obtaining a group of real coefficients $\hat{f}_j^c(0)$ based on the product $F(x, 0)$ of the average reaction cross section and energy at 0 Kelvin     130

Representing $F(x, \theta)$ as an approximate of a sum of an orthogonal function of the group of coefficient weights, using the group of coefficient $\hat{f}_j^c(0)$, calculating $F(x, \theta)$, and obtaining an average reaction cross section $\sigma(E, T)$     140

## FIG. 1

FIG. 2

FIG. 3A

FIG. 3B

FIG. 3C

FIG. 3D

## FIG. 3E

## FIG. 3F

FIG. 4A

FIG. 4B

200 K uranium (U) -235 total cross section relative error

FIG. 4C

3000 K uranium (U) -235 total cross section relative error

FIG. 4D

FIG. 4E

FIG. 4F

## FIG. 5A

## FIG. 5B

FIG. 5C

FIG. 5D

## FIG. 5E

## FIG. 5F

## INTERNATIONAL SEARCH REPORT

| International application No. |
|---|
| **PCT/CN2021/083775** |

**A. CLASSIFICATION OF SUBJECT MATTER**

G01T 1/34(2006.01)i

According to International Patent Classification (IPC) or to both national classification and IPC

**B. FIELDS SEARCHED**

Minimum documentation searched (classification system followed by classification symbols)

G01T

Documentation searched other than minimum documentation to the extent that such documents are included in the fields searched

Electronic data base consulted during the international search (name of data base and, where practicable, search terms used)

CNPAT, CNKI, WPI, EPODOC: 核, 截面, 展宽, 多普勒, 平均, 离散, 权, 反应, 函数, nuclear, neutron, cross, section, Doppler, spread+, broaden+, discret+, average, weight+

**C. DOCUMENTS CONSIDERED TO BE RELEVANT**

| Category* | Citation of document, with indication, where appropriate, of the relevant passages | Relevant to claim No. |
|---|---|---|
| A | CN 106405622 A (HEFEI INSTITUTES OF PHYSICAL SCIENCE, CHINESE ACADEMY OF SCIENCES) 15 February 2017 (2017-02-15) description, paragraphs [0006]-[0021], and figure 1 | 1-26 |
| A | CN 110274921 A (WUHAN UNIVERSITY) 24 September 2019 (2019-09-24) entire document | 1-26 |
| A | US 10502845 B2 (UNIVERSITY OR MARYLAND et al.) 10 December 2019 (2019-12-10) entire document | 1-26 |
| A | CN 107247286 A (PEKING UNIVERSITY et al.) 13 October 2017 (2017-10-13) entire document | 1-26 |
| A | CN 103257357 A (TAIYUAN UNIVERSITY OF TECHNOLOGY) 21 August 2013 (2013-08-21) entire document | 1-26 |
| A | CN 106814094 A (WUHAN UNIVERSITY) 09 June 2017 (2017-06-09) entire document | 1-26 |

☐ Further documents are listed in the continuation of Box C.       ☑ See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| **04 June 2021** | **30 June 2021** |

| Name and mailing address of the ISA/CN | Authorized officer |
|---|---|
| **China National Intellectual Property Administration (ISA/CN)** **No. 6, Xitucheng Road, Jimenqiao, Haidian District, Beijing 100088** **China** | |
| Facsimile No. **(86-10)62019451** | Telephone No. |

Form PCT/ISA/210 (second sheet) (January 2015)

## INTERNATIONAL SEARCH REPORT
### Information on patent family members

International application No.

**PCT/CN2021/083775**

| Patent document cited in search report | | | Publication date (day/month/year) | Patent family member(s) | | | Publication date (day/month/year) |
|---|---|---|---|---|---|---|---|
| CN | 106405622 | A | 15 February 2017 | CN | 106405622 | B | 05 April 2019 |
| CN | 110274921 | A | 24 September 2019 | None | | | |
| US | 10502845 | B2 | 10 December 2019 | EP | 3314304 | A1 | 02 May 2018 |
| | | | | WO | 2016210269 | A1 | 29 December 2016 |
| | | | | US | 2018188392 | A1 | 05 July 2018 |
| CN | 107247286 | A | 13 October 2017 | CN | 107247286 | B | 07 June 2019 |
| CN | 103257357 | A | 21 August 2013 | None | | | |
| CN | 106814094 | A | 09 June 2017 | CN | 106814094 | B | 10 September 2019 |

Form PCT/ISA/210 (patent family annex) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 201610782544